# EUROPÄISCHE PATENTSCHRIFT

(11) **EP 2 417 643 B1**
(45) Veröffentlichungstag und Bekanntmachung des Hinweises auf die Patenterteilung: **19.11.2014**
(21) Anmeldenummer: 10712366.3
(22) Anmeldetag: 17.02.2010
(51) Int. Cl.: H01L 41/083, H01L 41/047, H01L 41/277

(54) **PIEZOELEKTRISCHER AKTOR UND VERFAHREN ZUR HERSTELLUNG EINES PIEZOELEKTRISCHEN AKTORS**
PIEZOELECTRIC ACTUATOR AND METHOD FOR PRODUCING A PIEZOELECTRIC ACTUATOR
ACTIONNEUR PIÉZOÉLECTRIQUE ET PROCÉDÉ DE FABRICATION D'UN ACTIONNEUR PIÉZOÉLECTRIQUE

(30) Priorität: 09.04.2009 DE 102009002304
(43) Veröffentlichungstag der Anmeldung: 15.02.2012
(73) Patentinhaber: Robert Bosch GmbH, 70442 Stuttgart (DE)
(72) Erfinder: GRIESSL, Anja, 71691 Freiberg/Neckar (DE); ESCHENBACHER, Cosima, 71701 Schwieberdingen (DE); LINDNER, Friederike, 70839 Gerlingen (DE); HEJTMANN, Georg, 74395 Mundelsheim (DE); HENNECK, Stefan, 71229 Leonberg (DE); GUENTHER, Michael, 70736 Fellbach (DE); SPREMO, Ivan, 70197 Stuttgart (DE)
(86) Internationale Anmeldenummer: PCT/EP2010/051949
(87) Internationale Veröffentlichungsnummer: WO 2010/115650

(56) Entgegenhaltungen:
- EP-A1- 1 855 329
- DE-A1- 3 422 935
- JP-A- 2 114 683
- JP-A- 60 091 800
- US-A- 4 803 763

## Beschreibung

### Stand der Technik

Die Erfindung betrifft einen piezoelektrischen Aktor, insbesondere für ein Brennstoffeinspritzventil, ein Brennstoffeinspritzventil mit solch einem piezoelektrischen Aktor und ein Verfahren zur Herstellung eines piezoelektrischen Aktors. Speziell betrifft die Erfindung das Gebiet der Injektoren für Brennstoffeinspritzanlagen von Brennkraftmaschinen.

Aus der DE 100 62 672 A1 ist ein piezoelektrisches Bauelement in monolithischer Vielschichtbauweise mit einem Stapel aus mehreren Keramikschichten und jeweils zwischen zwei Keramikschichten angeordneten Elektrodenschichten sowie ein Verfahren zur Herstellung solch eines piezoelektrischen Bauelements bekannt. Das bekannte Bauelement ist aus keramischen Grünfolien hergestellt, die einen thermohydrolytisch abbaubaren Binder enthalten. Der Binder ist hierbei eine Polyurethandispersion. Das Verfahren zur Herstellung dieses Bauelements weist mehrere Schritte auf. Hierbei wird ein Stapel von den Binder enthaltenden keramischen Grünfolien und Elektrodenschichten durch Stapeln und anschließendes Laminieren der Grünfolien beziehungsweise der Elektrodenschichten hergestellt. Dann erfolgt ein Entbindern des Stapels in einer Atmosphäre, die Inertgas und Sauerstoff enthält, wobei der Sauerstoffgehalt durch Zudosieren einer geeigneten Menge Wasserstoffgas oder durch Getterung so reduziert wird, dass die Elektrodenschichten nicht beschädigt werden.

Das aus der DE 100 62 672 A1 bekannte piezoelektrische Bauteil und das bekannte Verfahren haben den Nachteil, dass die Herstellung aufwändig und somit die Herstellungskosten hoch sind.

EP 1855 329 A1 offenbart ein piezoelektrisches Element mit einer Mehrzahl von piezoelektrischen Schichten, wobei keramische Schichten durch vorgesinterte keramische Schichten gebildet sind und die keramischen Schichten mittels einer zwischen benachbarten keramischen Schichten vorgesehenen Elektrodenschicht aus einer metallischen Paste miteinander verbunden sind.

### Offenbarung der Erfindung

Der erfindungsgemäße piezoelektrische Aktor mit den Merkmalen des Anspruch 1, das erfindungsgemäße Brennstoffeinspritzventil mit den Merkmalen des Anspruchs 4 und das erfindungsgemäße Verfahren mit den Merkmalen des Anspruchs 5 haben den Vorteil, dass eine Herstellung des piezoelektrischen Aktors vereinfacht ist. Speziell kann eine Anzahl der Schichten des piezoelektrischen Aktors reduziert werden, wobei sich der Aufbau und die Herstellung des Aktors weiter vereinfachen.

Als piezoelektrische Aktoren können metallisierte, keramische Bauelemente aus piezoelektrischen Material zum Einsatz kommen. Solche piezoelektrischen Aktoren eignen sich besonders als Stellelemente. Ein bevorzugtes Anwendungsgebiet stellt die geregelte Einspritzung von Brennstoff in eine Brennkraftmaschine eines Kraftfahrzeugs dar. Hierbei kann die spannungs- oder ladungsgesteuerte Auslenkung des piezoelektrischen Aktors zur Positionierung eines Steuerventils genutzt werden, das wiederum den Hub einer Düsennadel regelt. Ein großer Vorteil eines piezoelektrischen Aktors ist dabei die Realisierung präziser und sehr schneller Auslenkungen mit hohen Kräften.

Um mit moderaten elektrischen Spannungen, die beispielsweise in einem Kraftfahrzeug zur Verfügung stehen, arbeiten zu können, sind Vielschichtaktoren von Vorteil, die einen Schichtverbund aus keramischen Schichten und metallischen Elektrodenschichten darstellen. Hierbei ist es möglich, dass die innenliegenden Elektrodenschichten wechselseitig nach außen geführt werden, um diese mit Außenelektroden zu kontaktieren. Zwischen der Außenelektrode und den zurückgesetzten Innenelektroden kann dabei jeweils eine isolierende Keramikschicht verbleiben. Die Elektrodenschichten einer Polarität sind dabei zusammengeschaltet, so dass eine Steuerspannung von beispielsweise 200 V an jeder aktiven Keramikschicht anliegt und ein elektrisches Feld von cirka 2 kV/mm entsteht. Beispielsweise können 300 keramische Schichten mit einer Schichtdicke von jeweils 90 µm und Elektrodenschichten aus Silber und Blei mit einer Dicke von jeweils etwa 2 µm bis etwa 3 µm zusammengestapelt werden.

Ferner ist es für den Aufbau von Vielschichtaktoren im Serienmaßstab denkbar, dass flexible keramische Folien mit einer Dicke von etwa 110 µm mit metallischen Elektrodenschichten bedruckt, aufgestapelt und im Laminierprozess bei hoher Temperatur und hohem Druck miteinander verbunden werden. Im folgenden Prozessschritt können aus auf diese Weise aufgebauten Blöcken eine Vielzahl von quaderförmigen Aktoren herausgesägt werden, während der folgende thermische Prozess, insbesondere ein Entbindern und Sintern; zunächst die organischen Bestandteile austreibt, um anschließend bei hoher Temperatur von ca. 1000° C den Sinterprozess zu beginnen. Bei der Sinterung entsteht ein polykristallines Keramikgefüge aus Körnern mit statistisch unterschiedlich orientierten Domänen. Wenn die keramischen Schichten und die metallischen Elektrodenschichten zusammen gesintert werden, erfolgt ein gemeinsames Sintern in einem Prozess, das heißt Co-Sintern. Nach dem Schleifen der Aktoroberflächen und dem Anbringen einer Grundmetallisierung auf den Außenelektrodenflächen kann eine Heißpolarisation erfolgen, nach der die keramischen Schichten einen bleibenden Polarisationszustand aufweisen. Hierdurch ist der Aktor polarisiert, so dass bei elektrischen Ansteuerungen eine reversible Längenänderung möglich ist.

Der Prozessschritt eines Entbinderns und Co-Sinterns ist allerdings mit hohen Kosten verbunden. In vorteilhafter Weise sind die keramischen Schichten des Aktorkörpers daher durch Keramikscheiben gebildet, die bereits gesintert sind. Diese Keramikscheiben können über die metallische Paste dann in vorteilhafter Weise miteinander verbunden werden. Somit können ein oder mehrere komplexe Prozessschritte, insbesondere ein Entbindern und Co-Sintern, entfallen. Ferner ist es hierbei möglich, dass teure Materialien eingespart werden können. Speziell kann Invar, das zum Ausbilden eines Außenelektrodengewebes geeignet ist, oder Palladium, das als Elektrodenmaterial geeignet ist, eingespart werden. Hierdurch ist eine weitere Kosteneinsparung und eine Vereinfachung der Herstellung möglich.

Außerdem ist es vorteilhaft, dass die Keramikscheiben eine relativ große Schichtdicke aufweisen. Insbesondere können die bereits gesinterten Keramikscheiben eine Schichtdicke von jeweils mehr als 100 µm aufweisen. Speziell kann eine Schichtdicke der Keramikscheiben jeweils auch sehr viel größer als 0,1 mm sein. Dadurch kann die Anzahl der keramischen Schichten erheblich reduziert werden. Dadurch vereinfacht sich der Aufbau des Aktorkörpers und somit des piezoelektrischen Aktors.

Außerdem besteht der Vorteil, dass ein Co-Sintern der keramischen Schichten und der Elektrodenschichten entfallen kann, so dass die Keramikeigenschaften unabhängig von den durch das Co-Sintern bestehenden Anforderungen (Begrenzungen) an das Material der Elektrodenschichten gewählt werden können. Speziell besteht beim Co-Sintern eine Begrenzung hinsichtlich der Schmelztemperatur eines Metalls für die Elektrodenschichten und hinsichtlich einer Metalldiffusion in die Keramik oder dergleichen. Durch das Vorsintern der Keramikscheiben entfallen solche Begrenzungen. Dadurch vereinfacht sich die Herstellung des piezoelektrischen Aktors. Außerdem können gegebenenfalls in Bezug auf den jeweiligen Anwendungsfall verbesserte Keramikeigenschaften vorgegeben und realisiert werden.

Eine Erhöhung der Schichtdicke der Keramikscheiben und somit der Dicke der keramischen Schichten des Aktorkörpers hat außerdem den Vorteil, dass die Gesamtkapazität des Aktorkörpers verringert ist. In der Regel verringert sich die Kapazität eines Aktors konstanter Länge quadratisch mit zunehmender Schichtdicke, wie es sich aus den elektrischen Gleichungen für Plattenkondensatoren ergibt. Somit können auch Steuergeräte oder dergleichen, die zum Ansteuern des piezoelektrischen Aktors, beispielsweise in einem Kraftfahrzeug, eingesetzt werden, für eine entsprechend reduzierte Leistung ausgelegt werden.

Erfindungsgemäß sind die Elektrodenschichten als vollflächige Elektrodenschichten ausgestaltet. Hierdurch ist eine hohe mechanische Stabilität des Aktorkörpers, insbesondere eine zuverlässige Verbindung der keramischen Schichten, gewährleistet. Weiters sind Außenelektroden vorgesehen, die die Elektrodenschichten kontaktieren, wobei die Außenelektroden als gefalzte Außenelektroden, insbesondere gefalzte Siebe oder gefalzte Bleche, ausgestaltet sind. Hierdurch ist eine alternierende Kontaktierung der Elektrodenschichten möglich, die kostengünstig herzustellen ist. Die Anbindung der Außenelektroden an die Elektrodenschichten kann mittels Postfiring, insbesondere mittels einer Metallpaste, durch Bonden oder Schweißen erfolgen. Das Falzen der Außenelektroden kann dabei so erfolgen, dass die gefalzten Außenelektroden den erforderlichen Isolationsabstand zu den gegenpoligen, innenliegenden Elektrodenschichten aufweisen. Die gegenpoligen, innenliegenden Elektrodenschichten werden dabei durch die jeweilige Außenelektrode sozusagen überbrückt.

Ferner ist es vorteilhaft, dass der Aktorkörper mit einer elektrisch hoch isolierenden Vergussmasse umgossen ist, die vorzugsweise eine hohe Reißdehnung aufweist. Die Kontaktierung der Außenelektroden kann beispielsweise mittels Lackdrähten oder durch Teflon beschichtete Leitungen realisiert werden.

Die keramischen Scheiben können aus einem Pulver auf der Basis einer PZT-Keramik gepresst und gesintert werden. Hierbei sind die keramischen Scheiben vorzugsweise durch Massivkeramikblöcke gebildet.

Ferner ist es vorteilhaft, dass die Keramikscheiben planparallele Stirnflächen aufweisen, die vollflächig mit der metallischen Paste bedruckt werden. Durch ein Aufeinanderstapeln, Verpressen und einen anschließenden thermischen Prozess, insbesondere ein Postfiring, kann dann ein Aktorkörper hergestellt werden, der eine hohe Stabilität aufweist und bei dem insbesondere die Keramikscheiben zuverlässig über die Elektrodenschichten miteinander verbunden sind.

Bevorzugte Ausführungsbeispiele sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 ein Brennstoffeinspritzventil mit einem piezoelektrischen Aktor in einer schematischen, auszugsweisen Schnittdarstellung entsprechend einem Ausführungsbeispiel der Erfindung und
Fig. 2 ein schematisches Ablaufdiagramm zur Veranschaulichung eines Verfahrens zur Herstellung eines piezoelektrischen Aktors entsprechend einem Ausführungsbeispiel der Erfindung.

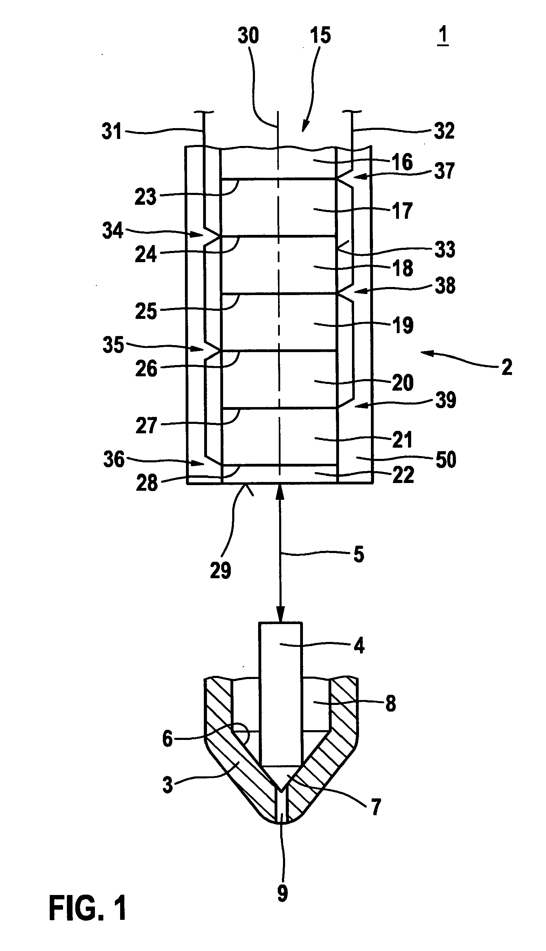

Fig. 1 zeigt ein Brennstoffeinspritzventil 1 mit einem piezoelektrischen Aktor 2 in einer auszugsweisen, schematischen Schnittdarstellung entsprechend einem Ausführungsbeispiel der Erfindung. Das Brennstoffeinspritzventil 1 kann insbesondere als Injektor für Brennstoffeinspritzanlagen von luftverdichtenden, selbstzündenden Brennkraftmaschinen oder von gemischverdichtenden, fremdgezündeten Brennkraftmaschinen dienen. Ein bevorzugter Einsatz des Brennstoffeinspritzventils 1 besteht für eine Brennstoffeinspritzanlage mit einem Common-Rail, das Dieselbrennstoff unter hohem Druck zu mehreren Brennstoffeinspritzventilen 1 führt. Der erfindungsgemäße piezoelektrische Aktor 2 eignet sich besonders für solch ein Brennstoffeinspritzventil 1. Das erfindungsgemäße Brennstoffeinspritzventil 1 und der erfindungsgemäße piezoelektrische Aktor 2 eignen sich jedoch auch für andere Anwendungsfälle.

Das Brennstoffeinspritzventil 1 weist einen Düsenkörper 3 auf, der auf geeignete Weise mit einem nicht dargestellten Ventilgehäuse verbunden ist. In dem Düsenkörper 3 ist eine Düsennadel 4 angeordnet, die von dem piezoelektrischen Aktor 2 betätigbar ist, wie es durch den Doppelpfeil 5 veranschaulicht ist. Der piezoelektrische Aktor 2 steht dabei mit der Düsennadel 4 in Wirkverbindung, wobei eine mittelbare Verbindung möglich ist.

An dem Düsenkörper 3 ist eine Ventilsitzfläche 6 ausgebildet. Ein Ventilschließkörper 7, der von der Düsennadel 4 betätigbar ist, wirkt mit der Ventilsitzfläche 6 zu einem Dichtsitz zusammen. In diesem Ausführungsbeispiel ist der Ventilschließkörper 7 einstückig mit der Düsennadel 4 ausgestaltet. Ferner ist in dem Düsenkörper 3 ein Brennstoffraum 8 vorgesehen, in dem sich im Betrieb unter hohem Druck stehender Brennstoff befindet. Bei einer Betätigung der Düsennadel 4 mittels des piezoelektrischen Aktors 2 hebt sich die Düsennadel 4 aus ihrem Sitz, so dass der zwischen der Ventilsitzfläche 6 und dem Ventilschließkörper 7 gebildete Dichtsitz geöffnet wird. Dadurch kann Brennstoff aus dem Brennstoffraum 8 über den geöffneten Dichtsitz und ein Düsenloch 9 in den Brennraum einer Brennkraftmaschine eingespritzt werden.

Der piezoelektrische Aktor 2 weist einen Aktorkörper 15 auf. Der Aktorkörper 15 umfasst eine Vielzahl von keramischen Schichten 16, 17, 18, 19, 20, 21, 22. Ferner weist der Aktorkörper 15 eine Vielzahl von zwischen den keramischen Schichten 16 bis 22 angeordneten Elektrodenschichten 23, 24, 25, 26, 27, 28 auf. Der Aktorkörper 15 ist in der Fig. 1 nur auszugsweise dargestellt.

Einzelne keramische Schichten, insbesondere die keramische Schicht 22, können auch als passive keramische Schichten ausgestaltet sein. Beispielweise kann die keramische Schicht 22 an einem Ende 29 des Aktorkörpers 15 vorgesehen sein, so dass diese im Betrieb nicht zur Dehnung und/oder Kontraktion des Aktorkörpers 15 entlang einer Längsachse 30 des Aktorkörpers 15 beiträgt.

Ferner weist der piezoelektrische Aktor 2 Außenelektroden 31, 32 auf. Die Außenelektroden 31, 32 sind hierbei an einer Außenseite 33 des Aktorkörpers 15 angeordnet. Die Außenelektrode 31 weist Falzstellen 34, 35, 36 auf, an denen die Außenelektrode 31 an die Außenseite 33 des Aktorkörpers 15 geführt ist. Die Außenelektrode 31 ist hierfür an den Falzstellen 34, 35, 36 gefalzt. Hierdurch ist ein Kontakt der Außenelektrode 31 mit den Elektrodenschichten 24, 26, 28 ermöglicht. Die Kontaktierung kann beispielsweise über Bonden oder Schweißen erfolgen. Ferner kann zur Kontaktierung auch eine Metallpaste im Bereich der Falzstellen 34, 35, 36 zwischen der Außenelektrode 31 und der Außenseite 33 des Aktorkörpers 15 angebracht werden. Nach einem thermischen Prozess, insbesondere einem Postfiring, ist die Außenelektrode 31 dann mit den Elektrodenschichten 24, 26, 28 verbunden.

Die Außenelektrode 32 weist Falzstellen 37, 38, 39 auf, an denen die Außenelektrode 32 zu der Außenseite 33 des Aktorkörpers 15 hin gefalzt ist. Die Außenelektrode 32 ist auf entsprechende Weise mit den Elektrodenschichten 23, 25, 27 elektrisch verbunden. Dadurch ist eine alternierende Kontaktierung der Elektrodenschichten 23 bis 28 durch die Außenelektroden 31, 32 möglich. Die Außenelektroden 31, 32 überbrücken hierbei jeweils die umgekehrt gepolten Elektrodenschichten. Die Außenelektrode 31 überbrückt die Elektrodenschichten 23, 25, 27. Die Außenelektrode 32 überbrückt die Elektrodenschichten 24, 26. Die Außenelektrode 32 endet an der Elektrodenschicht 27, so dass die Außenelektrode 32 die an dem Ende 29 des Aktorkörpers 15 liegende Elektrodenschicht 28 ohnehin nicht erreicht.

Somit können die Elektrodenschichten 23 bis 28 als vollflächige Elektrodenschichten 23 bis 28 ausgestaltet sein. Speziell ist eine alternierende Beabstandung der Elektrodenschichten 23 bis 28 von der Außenseite 33 des Aktorkörpers 15, die zum Verhindern eines elektrischen Kontakts mit einer jeweils anders gepolten Außenelektrode denkbar ist, nicht erforderlich. Somit können die Elektrodenschichten 23 bis 28 eine hohe Stabilität des Aktorkörpers 15 gewährleisten. Ferner können die keramischen Schichten 16 bis 21 zumindest im Wesentlichen über ihren gesamten Querschnitt, der senkrecht zu der Achse 30 orientiert ist, aktiviert werden. Dadurch ist ein optimiertes Dehnungs- und/oder Kontraktionsverhalten des Aktorkörpers 15 ermöglicht. Hierbei wird eine vorteilhafte Kraftentfaltung erzielt und es werden im Betrieb auftretende Spannungen in den keramischen Schichten 16 bis 22 reduziert, wodurch eine Rissbildung verhindert oder zumindest verringert ist.

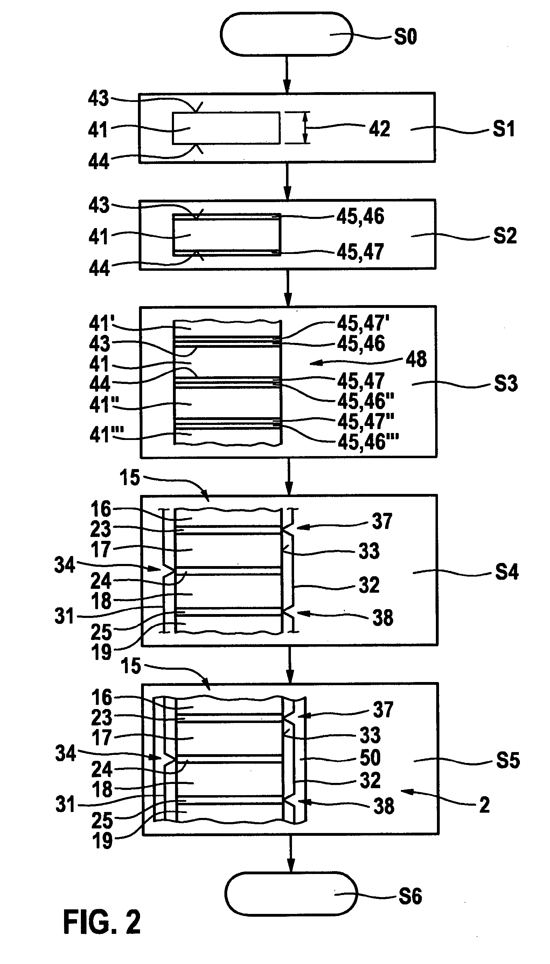

Fig. 2 zeigt ein schematisches Ablaufdiagramm zur Veranschaulichung eines Verfahrens zur Herstellung des piezoelektrischen Aktors 2 des Brennstoffeinspritzventils 1. Mit dem Schritt S0 beginnt das Verfahren. In dem folgenden Schritt S1 werden mehrere keramische Scheiben 41 aus einem piezoelektrischen Material hergestellt. Solch eine keramische Scheibe 41 weist eine relativ große Dicke (Schichtdicke) 42 auf. Beispielsweise kann die Dicke 42 deutlich größer als 0,1 mm sein. Die keramische Scheibe 41 weist Stirnflächen 43, 44 auf. Die Stirnflächen 43, 44 werden dabei planparallel geschliffen oder geläppt. Hierdurch kann innerhalb gewisser Grenzen die Dicke 42 der keramischen Schicht 41 abgestimmt werden.

Die keramische Scheibe 41 wird im Schritt S1 außerdem gesintert. Dadurch ist ein Vorsintern der keramischen Scheibe 41 möglich. Komplexe Prozessschritte, beispielsweise ein Entbindern oder ein Co-Sintern, können dadurch entfallen. Ferner können teure Materialien eingespart werden. Beispielsweise kann das Material der Außenelektroden 31, 32 geringeren Anforderungen genügen, so dass diese beispielsweise aus einem anderen Material als Invar gebildet sein können. Ferner können die Elektrodenschichten 23 bis 28 aus einem günstigen metallischen Werkstoff gebildet sein. Relativ teure Werkstoffe wie Palladium sind dabei nicht erforderlich.

Im Schritt S2, der auf den Schritt S1 folgt, werden die keramischen Scheiben 41 an zumindest einer Stirnfläche 43, 44 beschichtet. Beispielsweise wird die keramische Scheibe 41 an beiden Stirnflächen 43, 44 mit einer metallischen Paste 45 bedruckt. Auf die Stirnflächen 43, 44 sind dann Pastenschichten 46, 47 aus der metallischen Paste 45 gedruckt.

Im folgenden Schritt S3 wird die keramische Scheibe 41 mit weiteren, entsprechend der keramischen Scheibe 41 ausgestalteten und bedruckten keramischen Scheiben 41',41 ", 41"' gestapelt, wodurch ein Verbund 48 gebildet ist. In dem Verbund 48 kommt eine aus der Paste 45 bestehende Pastenschicht 47' der keramischen Scheibe 41' mit der aus der metallischen Paste 45 bestehenden Pastenschicht 46 vollflächig in Berührung. Ferner kommt die aus der metallischen Paste 45 bestehende Pastenschicht 47 der keramischen Scheibe 41 vollflächig mit der aus der keramischen Paste 45 bestehenden Pastenschicht 46" der keramischen Scheibe 41" in Berührung. Außerdem kommt die aus der metallischen Paste 45 bestehende Pastenschicht 47" der keramischen Scheibe 41" vollflächig mit der aus der metallischen Paste 45 bestehenden Pastenschicht 46'" der keramischen Scheibe 41"' in Berührung. Beim Verpressen des Verbundes 48 entsteht somit eine gewisse Verbindung der keramischen Scheiben 41, 41', 41", 41"' über die aus der metallischen Paste 45 gebildeten Pastenschichten 46, 46', 46", 46"', 47, 47', 47", 47"'.

Anschließend wird im Schritt S3 ein thermischer Prozess, insbesondere ein Postfiring, zum Verbinden der gestapelten, bedruckten keramischen Scheiben 41, 41', 41", 41"' durchgeführt.

Zu Beginn des Schritts S4, der auf den Schritt S3 folgt, sind somit durch den thermischen Prozess die in der Fig. 2 dargestellten Elektrodenschichten 23 bis 25 sowie weitere Elektrodenschichten 26, 27, 28 gebildet. Beispielsweise wird die Elektrodenschicht 24 durch die aus der metallischen Paste 45 gebildeten Pastenschichten 46", 47 zwischen den keramischen Scheiben 41, 41" gebildet. Die keramische Scheibe 41 bildet hierbei die keramische Schicht 17. Ferner bilden die keramischen Scheiben 41', 41", 41"' die keramischen Schichten 16, 18, 19 des Aktorkörpers 15. Nach einem gegebenenfalls an der Außenseite 33 des Aktorkörpers 15 erfolgenden Schleifprozess werden die gefalzten Außenelektroden 31, 32 angebracht und mit den Elektrodenschichten 23 bis 28 elektrisch verbunden.

Die Elektrodenschichten 23 bis 28 sind als vollflächige Elektrodenschichten 23 bis 28 ausgestaltet. Dadurch sind die keramischen Schichten 16 bis 22 mit einer hohen Festigkeit miteinander verbunden. Somit kann eine hohe mechanische Stabilität des Aktorkörpers 15 gewährleistet werden.

Im Schritt S5, der auf den Schritt S4 folgt, wird der mit den Außenelektroden 31, 32 versehene Aktorkörper 15 mit einer elektrisch hoch isolierenden Vergussmasse 50 umgossen. Die Vergussmasse 50 weist dabei eine hohe Reißdehnung auf.

Somit ist der piezoelektrische Aktor 2 gebildet. Die Kontaktierung der Außenelektroden 31, 32 kann beispielsweise mittels Lackdrähten oder Teflon beschichteten Leitungen realisiert werden. Das beschriebene Verfahren endet im Schritt S6.

Die Erfindung ist nicht auf die beschriebenen Ausführungsbeispiele beschränkt.

## Patentansprüche

1. Piezoelektrischer Aktor (2), insbesondere Aktor für Brennstoffeinspritzventile, mit einem Aktorkörper (15), der mehrere keramische Schichten (16 - 22) und mehrere zwischen den keramischen Schichten (16 - 22) angeordnete Elektrodenschichten (23 - 28) aufweist, wobei
eine erste keramische Schicht (17) durch eine erste vorgesinterte keramische Scheibe (41) gebildet ist, zumindest eine zweite keramische Schicht (18) durch eine zweite vorgesinterte keramische Scheibe (41") gebildet ist und die durch die erste keramische Scheibe (41) gebildete keramische Schicht (17) und die durch die zweite keramische Scheibe (41") gebildete keramische Schicht (18) mittels einer zwischen der ersten keramischen Schicht (17) und der zweiten keramischen Schicht (18) vorgesehenen Elektrodenschicht (24) miteinander verbunden sind, wobei die Elektrodenschicht (24) aus zumindest einer metallischen Paste (45) gebildet ist, wobei die zwischen der ersten keramischen Schicht (17) und der zweiten keramischen Schicht (18) vorgesehene Elektrodenschicht (24) als vollflächige Elektrodenschicht (24) ausgestaltet ist und Außenelektroden (31, 32) vorgesehen sind, die die Elektrodenschichten (23 - 28) kontaktieren,
**dadurch gekennzeichnet,**
**dass** die Außenelektroden (31, 32) als gefalzte Außenelektroden (31, 32) ausgestaltet sind.

2. Piezoelektrischer Aktor nach Anspruch 1,
**dadurch gekennzeichnet,**
**dass** die metallische Paste (45) auf einem metallischen Werkstoff basiert.

3. Piezoelektrischer Aktor nach Anspruch 1 oder 2,
**dadurch gekennzeichnet,**
**dass** die keramischen Scheiben (41, 41") eine Schichtdicke (42) von jeweils größer als 0,1 mm aufweisen.

4. Brennstoffeinspritzventil (1), insbesondere Injektor für Brennstoffeinspritzanlagen von luftverdichtenden, selbstzündenden Brennkraftmaschinen, mit einem piezoelektrischen Aktor (2) nach einem der Ansprüche 1 bis 3 und einem von dem piezoelektrischen Aktor (2) betätigbaren Ventilschließkörper (7), der mit einer Ventilsitzfläche (6) zu einem Dichtsitz zusammenwirkt.

5. Verfahren zur Herstellung eines piezoelektrischen Aktors nach einem der Ansprüche 1 bis 3, das folgende Verfahrensschritte aufweist:
a) Herstellen von mehreren keramischen Scheiben (41, 41', 41", 41"') aus einem piezoelektrischen Material;
b) Sintern der keramischen Scheiben (41, 41', 41", 41"');
c) zumindest einseitiges Bedrucken der keramischen Scheiben (41, 41', 41", 41"') mit einer metallischen Paste (45);
d) Stapeln der bedruckten keramischen Scheiben (41, 41', 41", 41"') und
e) Verbinden der gestapelten, bedruckten keramischen Scheiben (41, 41', 41", 41"') durch zumindest einen thermischen Prozess.

6. Verfahren nach Anspruch 5,
**dadurch gekennzeichnet,**
**dass** zumindest fast alle keramische Scheiben (41, 41', 41", 41"') beidseitig mit der metallischen Paste (45) bedruckt werden.

7. Verfahren nach Anspruch 5 oder 6,
**dadurch gekennzeichnet,**
**dass** die keramischen Scheiben (41, 41', 41", 41"')
vollflächig mit der metallischen Paste (45) bedruckt werden.

8. Verfahren nach einem der Ansprüche 5 bis 7,
**gekennzeichnet durch** folgende Verfahrensschritte:
Anbringen von gefalzten Außenelektroden (31, 32) und
Kontaktieren der gefalzten Außenelektroden (31, 32) mit Elektrodenschichten (23, 28), die **durch** die zwischen den keramischen Scheiben (41, 41', 41", 41"') vorgesehene metallische Paste (45) gebildet werden.

9. Verfahren nach einem der Ansprüche 5 bis 8,
**dadurch gekennzeichnet,**
**dass** der thermische Prozess zum Verbinden der gestapelten, bedruckten keramischen Scheiben (41, 41', 41", 41"') als Postfiring-Prozess ausgestaltet ist.

## Claims

1. Piezoelectric actuator (2), in particular an actuator for fuel injection valves, having an actuator body (15), which comprises a plurality of ceramic layers (16 - 22) and a plurality of electrode layers (23 - 28) arranged between the ceramic layers (16 - 22), wherein a first ceramic layer (17) is formed by a first pre-sintered ceramic disc (41), at least one second ceramic layer (18) is formed by a second pre-sintered ceramic disc (41") and the ceramic layer (17) formed by the first ceramic disc (41) and the ceramic layer (18) formed by the second ceramic disc (41") are connected to one another by an electrode layer (24) provided between the first ceramic layer (17) and the second ceramic layer (18), wherein the electrode layer (24) is formed from at least one metallic paste (45), wherein the electrode layer (24) provided between the first ceramic layer (17) and the second ceramic layer (18) is designed as a full-area electrode layer (24) and outer electrodes (31, 32) that contact the electrode layers (23 - 28) are provided, **characterized in that** the outer electrodes (31, 32) are designed as folded outer electrodes (31, 32).

2. Piezoelectric actuator according to Claim 1, **characterized in that** the metallic paste (45) is based on a metallic material.

3. Piezoelectric actuator according to Claim 1 or 2, **characterized in that** the ceramic discs (41, 41") have a layer thickness (42) of in each case greater than 0.1 mm.

4. Fuel injection valve (1), in particular an injector for fuel injection systems of air-compressing, self-igniting internal combustion engines, having a piezoelectric actuator (2) according to one of Claims 1 to 3 and a valve closing body (7), which can be actuated by the piezoelectric actuator (2) and interacts with a valve seating face (6) to form a sealing seat.

5. Method for producing a piezoelectric actuator according to one of Claims 1 to 3, which has the following method steps:
a) producing a plurality of ceramic discs (41, 41', 41", 41"') from a piezoelectric material;
b) sintering the ceramic discs (41, 41', 41", 41"');
c) printing a metallic paste (45) onto at least one side of the ceramic discs (41, 41', 41", 41"');
d) stacking the printed ceramic discs (41, 41', 41", 41"') and
e) connecting the stacked, printed ceramic discs (41, 41', 41", 41"') by at least one thermal process.

6. Method according to Claim 5, **characterized in that** at least almost all of the ceramic discs (41, 41', 41", 41"') are printed on both sides with the metallic paste (45).

7. Method according to Claim 5 or 6, **characterized in that** the ceramic discs (41, 41', 41", 41"') are printed with the metallic paste (45) over their full surface area.

8. Method according to one of Claims 5 to 7, **characterized by** the following method steps:
attaching folded outer electrodes (31, 32) and
establishing electrical contact between the folded outer electrodes (31, 32) and electrode layers (23, 28), which are formed by the metallic paste (45) provided between the ceramic discs (41, 41', 41", 41"').

9. Method according to one of Claims 5 to 8, **characterized in that** the thermal process for connecting the stacked, printed ceramic discs (41, 41', 41", 41"') is designed as a postfiring process.

## Revendications

1. Actionneur piézoélectrique (2), en particulier actionneur pour soupapes d'injection de carburant, comprenant un corps d'actionneur (15) qui présente plusieurs couches céramiques (16-22) et plusieurs couches d'électrodes (23-28) disposées entre les couches céramiques (16-22),
une première couche céramique (17) étant formée par un premier disque céramique préfritté (41), au moins une deuxième couche céramique (18) étant formée par un deuxième disque céramique préfritté (41") et la couche céramique (17) formée par le premier disque céramique (41) et la couche céramique (18) formée par le deuxième disque céramique (41") étant connectées l'une à l'autre au moyen d'une couche d'électrodes (24) prévue entre la première couche céramique (17) et la deuxième couche céramique (18), la couche d'électrodes (24) étant formée d'au moins une pâte métallique (45), la couche d'électrodes (24) prévue entre la première couche céramique (17) et la deuxième couche céramique (18) étant configurée sous forme de couche d'électrodes sur toute la surface (24) et des électrodes extérieures (31, 32) étant prévues, lesquelles viennent en contact avec les couches d'électrodes (23-28),
**caractérisé en ce que**
les électrodes extérieures (31, 32) sont configurées sous forme d'électrodes extérieures pliées (31, 32).

2. Actionneur piézoélectrique selon la revendication 1,
**caractérise en ce que**
la pâte métallique (45) est à base d'un matériau métallique.

3. Actionneur piézoélectrique selon la revendication 1 ou 2,
**caractérisé en ce que**
les disques céramiques (41, 41") présentent une épaisseur de couche (42) à chaque fois supérieure à 0,1 mm.

4. Soupape d'injection de carburant (1), en particulier injecteur pour installations d'injection de carburant de moteurs à combustion interne à auto-allumage et compression d'air, comprenant un actionneur piézoélectrique (2) selon l'une quelconque des revendications 1 à 3, et un corps de fermeture de soupape (7) pouvant être commandé par l'actionneur piézoélectrique (2), lequel coopère avec une surface de siège de soupape (6) pour former un siège d'étanchéité.

5. Procédé de fabrication d'un actionneur piézoélectrique selon l'une quelconque des revendications 1 à 3, présentant les étapes de procédé suivantes :
a) fabrication de plusieurs disques céramiques (41, 41', 41", 41"') en un matériau piézoélectrique ;
b) frittage des disques céramiques (41, 41', 41'', 41"');
c) impression au moins d'un côté des disques céramiques (41, 41', 41", 41"') avec une pâte métallique (45) ;
d) empilement des disques céramique imprimés (41, 41', 41", 41"') et
e) assemblage des disques céramique imprimés empilés (41, 41', 41", 41"') par au moins un processus thermique.

6. Procédé selon la revendication 5,
**caractérisé en ce**
**qu'**au moins presque tous les disques céramiques (41, 41', 41", 41"') sont imprimés des deux côtés avec la pâte métallique (45).

7. Procédé selon la revendication 5 ou 6,
**caractérisé en ce que**
les disques céramiques (41, 41', 41", 41"') sont imprimés sur toute la surface avec la pâte métallique (45).

8. Procédé selon l'une quelconque des revendications 5 à 7,
**caractérisé par** les étapes de procédé suivantes :
montage d'électrodes extérieures pliées (31, 32) et
mise en contact des électrodes extérieures pliées (31, 32) avec des couches d'électrodes (23, 28) qui sont formées par la pâte métallique (45) prévue entre les disques céramiques (41, 41', 41", 41"').

9. Procédé selon l'une quelconque des revendications 5 à 8,
**caractérisé en ce que**
le processus thermique d'assemblage des disques céramiques imprimés empilés (41, 41', 41", 41"') est configuré en tant que processus de post-cuisson.
